(19) Europäisches Patentamt
European Patent Office
Office européen des brevets

(11) **EP 3 417 481 B1**

(12) **FASCICULE DE BREVET EUROPEEN**

(45) Date de publication et mention
de la délivrance du brevet:
**25.03.2020 Bulletin 2020/13**

(21) Numéro de dépôt: **17704275.1**

(22) Date de dépôt: **14.02.2017**

(51) Int Cl.:
*H01L 25/065* (2006.01)  *H01L 21/98* (2006.01)
*H01L 23/49* (2006.01)  *H01L 21/60* (2006.01)
*H01L 23/66* (2006.01)

(86) Numéro de dépôt international:
**PCT/EP2017/053256**

(87) Numéro de publication internationale:
**WO 2017/140661 (24.08.2017 Gazette 2017/34)**

(54) **PROCEDE D'INTERCONNEXION DANS UN MODULE ELECTRONIQUE 3D**

VERFAHREN ZUR ELEKTRISCHEN VERBINDUNG IN EINEM ELEKTRONISCHEN 3D-MODUL

INTERCONNECTION METHOD IN A 3D ELECTRONIC MODULE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **19.02.2016 FR 1651390**

(43) Date de publication de la demande:
**26.12.2018 Bulletin 2018/52**

(73) Titulaire: **3D Plus
78530 Buc (FR)**

(72) Inventeur: **VAL, Christian
78470 Saint-Rémy-les-Chevreuse (FR)**

(74) Mandataire: **Henriot, Marie-Pierre
Marks & Clerk France
Conseils en Propriété Industrielle
Immeuble Visium
22, Avenue Aristide Briand
94117 Arcueil Cedex (FR)**

(56) Documents cités:
**EP-A1- 0 638 933      EP-A1- 2 053 646
WO-A1-2014/063287   US-A1- 2007 035 007**

**Description**

Le domaine de l'invention est celui des modules électroniques 3D et plus précisément celui de l'interconnexion de puces empilées.

Une solution pour interconnecter des puces empilées les unes sur les autres consiste à utiliser les faces verticales de l'empilement qui sont métallisées pour réaliser les connexions électriques entre puces. Ces puces comportent des plots de connexion connectés à des billes de connexion, mais ne comportent pas de fils de câblage électrique issus de ces plots. Une telle solution aussi désignée technologie WDoD est décrite dans le brevet FR 2 857 157 (Inventeurs : Val Christian et Lignier Olivier) et FR 2 905 198 (Inventeur : Val Christian). Mais elle est couteuse à mettre en œuvre.

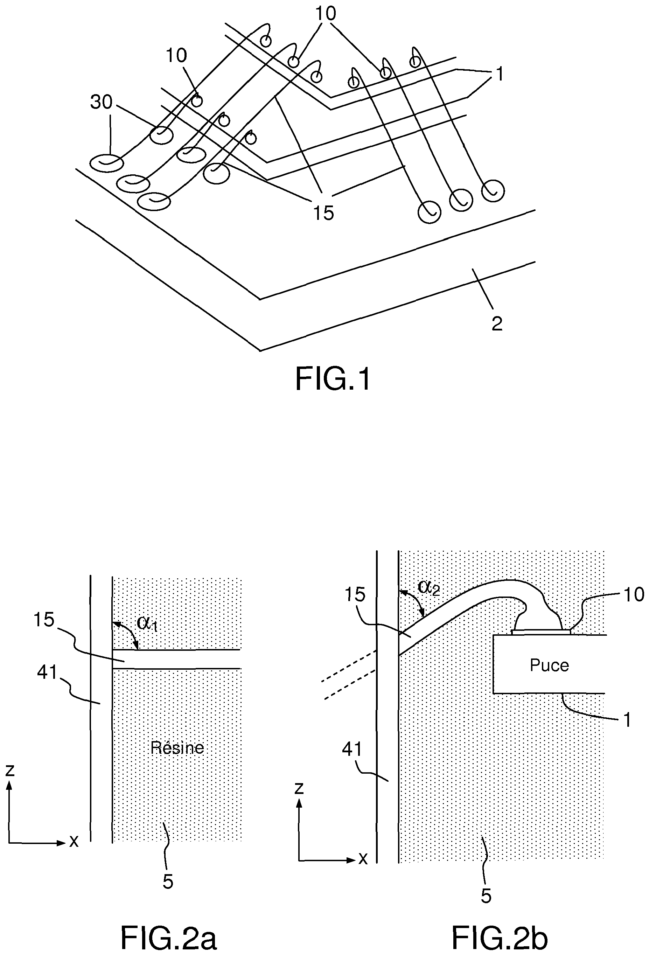

Une solution moins couteuse consiste à utiliser la technologie Chip on Chip (CoC) de puces empilées et câblées. Un exemple de module électronique 3D obtenu par cette technologie est montré figure 1 avec deux puces 1 empilées sur un substrat d'interconnexion 2 tel qu'un PCB acronyme de l'expression anglo-saxonne Printed Circuit Board. On observe que les nappes de fils 15 câblés de manière régulière relient les plots 10 de chaque puce 1 aux soudures 30 du substrat 2 sur lequel est collée la première puce, la deuxième puce étant collée sur la première.

L'empilage de puces avec la technologie Chip on Chip (CoC) est à ce jour l'un des plus denses et des plus utilisés dans le monde (cas des téléphone etc....). Les puces 1 empilées comportent des plots de connexion 10 et des fils 15 de câblage électrique issus de ces plots.

Mais la surface « au sol » ou horizontale (c'est-à-dire dans un plan x,y perpendiculaire à la direction z de l'empilement) prise par un empilement obtenu par cette technologie CoC, est en général 2 fois plus élevée que celle obtenue par la technologie WDoD. Les puces de taille variable, de surfaces horizontales typiquement comprises entre 6x6 mm$^2$ pour de petites puces et 9x9 mm$^2$ pour de grandes puces, sont généralement empilées sur un circuit d'interconnexion 2 destiné à l'interconnexion de l'empilement avec un autre circuit extérieur au moyen de billes de connexion. Dans le cas d'un empilement de puces de surfaces variables, elles sont empilées selon leur surface décroissante (la plus grande puce est en bas de l'empilement sur le PCB, et la plus petite en haut de l'empilement).

Les soudures 30 sur le substrat support prennent une place importante. Il est estimé qu'au niveau de ces soudures, la distance entre chaque nappe de fils varie de 400 $\mu$m à 800 $\mu$m, soit en moyenne 500 $\mu$m. Pour quatre puces empilées on obtient une distance de 4 x 500 $\mu$m = 2000 $\mu$m = 2 mm autour de l'empilement, soit pour l'empilement muni de ses fils de câblage électrique, une surface horizontale de :

- (6 mm + (2 x 2mm)) x (6 mm + (2 x 2mm)) = 100 mm$^2$ pour un empilement de quatre petites puces, alors qu'avec le WDoD on a 100 $\mu$m autour des puces ce qui conduit à une surface de 6,2 x 6,2 = 38,5 mm$^2$, soit 2,5 fois plus de surface avec la technologie CoC et

- (9 mm + (2 x 2mm)) x (9 mm + (2 x 2mm)) = 169 mm$^2$ pour un empilement de quatre puces avec au moins une grande puce, alors que le WDoD conduit à une surface 9,2 x 9,2 = 84,6 mm$^2$, soit 2 fois plus de surface avec la technologie CoC.

Par ailleurs, la longueur des fils de câblage varie de 1 à 3 entre la nappe la plus proche de la puce et la nappe la plus éloignée.

L'ensemble {empilement avec PCB- fils câblés sur le substrat} est ensuite moulé dans de la résine, puis découpé pour obtenir un module électronique 3D prêt à être livré à un équipementier.

Un autre exemple de module électronique 3D est décrit dans le document WO 2014/063287.

En outre un problème d'intégrité du signal apparaît lorsque l'empilement comporte des puces fonctionnant dans le domaine des hyperfréquences notamment au-delà de 2 GHz.

En conséquence, il demeure à ce jour un besoin pour un procédé d'interconnexion de puces empilées donnant simultanément satisfaction à l'ensemble des exigences précitées, en termes de coût de fabrication, de surface « au sol », et d'intégrité des signaux aux hyperfréquences.

Plus précisément l'invention a pour objet un module électronique 3D selon la revendication 1, ce module comportant selon une direction dite verticale un empilement de tranches électroniques, chaque tranche comportant au moins une puce munie de plots d'interconnexion. Cet empilement est assemblé à un circuit d'interconnexion du module, muni de billes de connexion. Les plots de chaque puce sont connectés par des fils de câblage électrique à des bus verticaux eux-mêmes électriquement reliés au circuit d'interconnexion du module, un fil de câblage et le bus vertical auquel il est relié formant un conducteur électrique entre un plot d'une puce et le circuit d'interconnexion. L'empilement de tranches, le circuit d'interconnexion et les fils de câblage sont moulés dans une résine époxy, les bus verticaux sont situés dans le moulage en résine époxy ou sur une ou plusieurs surfaces verticales du moulage en résine époxy. Par ailleurs, le module selon la revendication 1 est tel que chaque fil de câblage électrique est relié à son bus vertical en formant dans un plan vertical un angle oblique et tel que la longueur du fil de câblage entre un plot d'une puce d'une tranche et un bus vertical est différente de la longueur du fil de câblage entre un même plot d'une puce d'une autre tranche et ledit bus vertical. En outre, le module selon la revendication 1 est caractérisé en ce que cette différence de longueur est obtenue par un câblage non rectiligne du fil de câblage pour compenser la différence de longueur verticale du bus vertical d'une tranche à l'autre de manière à ce que le conducteur électrique entre le plot d'une puce d'une tranche et le circuit d'interconnexion, et le conducteur électrique entre ledit même plot d'une puce de l'autre tranche et le circuit d'interconnexion, aient la même longueur.

Selon un mode de réalisation, le circuit d'interconnexion comporte des fils de câblage obliques et les bus verticaux sont dans un plan situé en dehors du circuit d'interconnexion.

Selon un autre mode de réalisation, le circuit d'interconnexion ne comporte pas de fils de câblage et les bus verticaux traversent le circuit d'interconnexion.

Les puces peuvent être aptes à fonctionner à plus d'1 GHz.

Les bus verticaux, lorsqu'ils sont obtenus par métallisation et gravure, sont situés sur une ou plusieurs faces verticales du moulage en résine époxy et présentent généralement une épaisseur inférieure à $10\mu m$, l'épaisseur d'un bus vertical étant la distance entre la surface extérieure dudit bus vertical et la surface de moulage en résine époxy sur laquelle ledit bus vertical se situe.

Selon une alternative, les bus verticaux sont sous forme de vias métallisés.

Un circuit électronique à composants passifs et comportant des fils de câblage peut être inséré dans l'empilement.

L'invention a aussi pour objet un procédé de fabrication d'un module électronique 3D tel que précédemment décrit. Ce procédé, qui fait l'objet de la revendication 9, est caractérisé en ce qu'il comporte les étapes suivantes réalisées collectivement :

A) empilement d'une tranche électronique sur le circuit d'interconnexion, et connexion des plots de la puce (ou des puces) à un substrat métallisé situé au même niveau que le circuit d'interconnexion, par des fils de câblage, de manière à obtenir des fils de câblage inclinés dans un plan vertical, itération de cette étape avec une nouvelle tranche électronique empilée sur l'empilement précédent jusqu'à obtenir un empilement prédéfini,

B) dépôt d'une résine époxy pour mouler l'empilement et ses fils de câblage, et le circuit d'interconnexion,

C) découpe verticale de la résine selon des plans verticaux situés en dehors de l'empilement pour obtenir plusieurs boîtiers,

et en ce qu'il comporte l'étape suivante réalisée individuellement pour chaque boîtier : métallisation et gravure des faces verticales du boîtier pour former les bus verticaux et obtenir un module électronique 3D.

Selon l'alternative de la revendication 10, le procédé de fabrication d'un module électronique 3D comporte les étapes suivantes réalisées collectivement :

A) empilement d'une tranche électronique sur le circuit d'interconnexion, et connexion des plots de la puce (ou des puces) à un substrat métallisé situé au même niveau que le circuit d'interconnexion, par des fils de câblage, de manière à obtenir des fils de câblage inclinés dans un plan vertical, itération de cette étape avec une nouvelle tranche électronique empilée sur l'empilement précédent jusqu'à obtenir un empilement prédéfini,

B) dépôt d'une résine époxy pour mouler l'empilement et ses fils de câblage, et le circuit d'interconnexion,

C) percements de vias à travers la résine en dehors de l'empilement, et métallisation des vias pour former les bus verticaux,

D) découpe verticale de la résine selon des plans verticaux au-delà des vias pour obtenir plusieurs boîtiers.

Le circuit d'interconnexion peut ne pas comporter de fils de câblage ; la découpe est alors réalisée dans un plan vertical traversant le circuit PCB.

Le circuit d'interconnexion peut comporter des fils de câblage reliés au substrat métallisé ; la découpe est alors réalisée dans un plan vertical situé entre le circuit d'interconnexion et le substrat métallisé et les fils de câblage forment dans le plan vertical de découpe, un angle oblique.

D'autres caractéristiques et avantages de l'invention apparaîtront à la lecture de la description détaillée qui suit, faite à titre d'exemple non limitatif et en référence aux dessins annexés dans lesquels :

la figure 1 déjà décrite représente schématiquement en coupe un exemple de module électronique 3D obtenu par la technologie CoC selon l'état de la technique,

les figures 2 illustrent schématiquement en coupe, des connexions électriques à angles droits (fig 2a) et à angles obliques (non droits) (fig 2b),

la figure 3 représente schématiquement en coupe un exemple de module électronique 3D avec un circuit PCB standard, en cours de fabrication par le procédé selon l'invention,

la figure 4 représente schématiquement en coupe un exemple de module électronique 3D avec un circuit PCB à fils de câblage, en cours de fabrication par le procédé selon l'invention,

les figures 5 représentent schématiquement un mode de réalisation de bus verticaux sous forme de vias vus de dessus (fig 5a) et vus en coupe (fig 5b),

la figure 6 représente schématiquement vu en perspective un exemple de module électronique 3D selon l'invention avec des fils de câblage non rectilignes, des bus verticaux gravés et un PCB sans fils de câblage.

D'une figure à l'autre, les mêmes éléments sont repérés par les mêmes références.

Dans la suite de la description, les expressions « haut », « bas », sont utilisées en référence à l'orientation des figures décrites. Dans la mesure où le module électronique 3D peut être positionné selon d'autres orientations, la terminologie directionnelle est indiquée à titre d'illustration et n'est pas limitative.

La solution selon l'invention est basée sur une combinaison astucieuse des technologies CoC et WDoD. Les puces sont empilées sur un circuit d'interconnexion avec la technologie CoC et l'ensemble est moulé dans de la résine. Puis selon la technologie WDoD, cet ensemble est découpé verticalement et les fils de câblage affleurant au niveau des faces découpées sont alors connectés à des bus métalliques verticaux pour assurer l'interconnexion verticale des puces entre elles et avec le circuit d'interconnexion.

La demanderesse a identifié la cause du problème de fonctionnement dans le domaine des hyperfréquences d'un module électronique 3D à connexions verticales sur les faces de l'empilement. En effet, lors de connexions en T entre conducteurs électriques (conducteurs 15 issus des puces 1 et conducteurs verticaux 41) disposés à angles droits ($\alpha1=90°$) comme montré figure 2a, une réflexion d'électrons se produit au niveau de la connexion, qui perturbe la connexion électrique et l'affaiblit.

La solution selon l'invention pour éviter ces réflexions d'électrons, est de réaliser au niveau des connexions avec les bus verticaux 41, des connexions obliques c'est-à-dire à angles obliques ou non droits ($\alpha2<90°$ ou $\alpha2>90°$) comme montré figure 2b, tout en maintenant une surface horizontale minimale pour l'empilement.

On va à présent détailler les étapes du procédé de fabrication d'un tel module électronique 3D.

Le substrat de l'empilement est fabriqué. Il s'agit d'un circuit d'interconnexion 2 généralement multicouches qui peut être un PCB incluant des fils conducteurs de cuivre ou un substrat en alumine incluant des fils conducteurs de tungstène, de nickel ou d'or. Dans la suite on va prendre comme exemple de circuit d'interconnexion, un PCB. Celui-ci peut présenter plusieurs configurations :

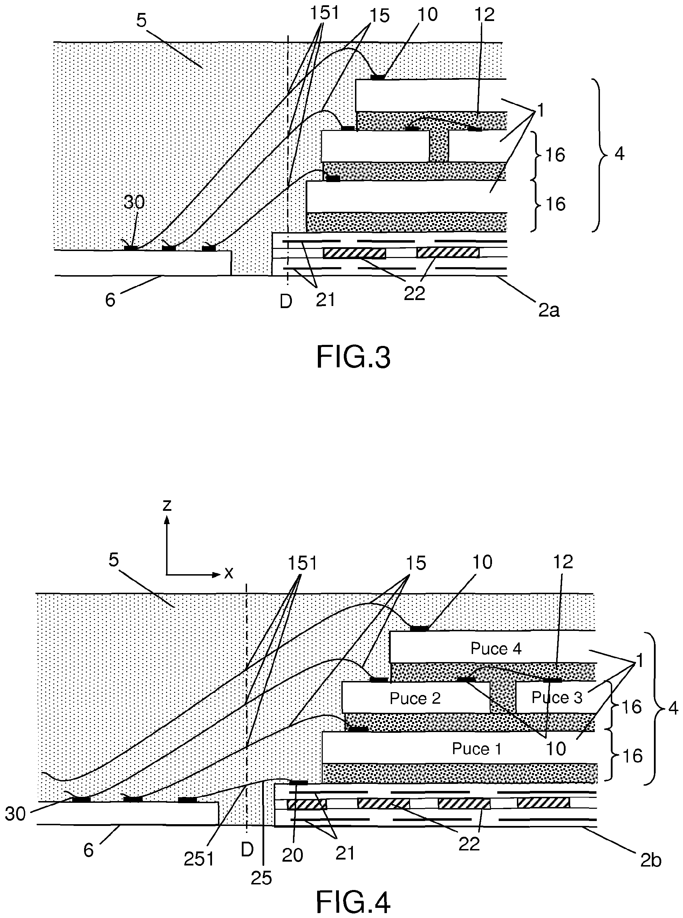

- PCB standard 2a, c'est-à-dire sans fils de câblage, à surface horizontale plus grande que celle de l'empilement 4 de manière à être lui-même découpé lors de la découpe selon un plan D, de l'ensemble moulé dans la résine 5 comme indiqué figure 3 : l'interconnexion verticale entre le PCB 2a et les sections 151 des fils 15 de câblage issus des puces 1 et affleurant au niveau des faces découpées de l'empilement, se fait en réalisant des bus verticaux 41 connectés aux sections affleurant 151 et venant intercepter les conducteurs métalliques 21 inclus dans le PCB.

- Pour certaines applications dont les applications spatiales, il est préférable de ne pas découper le circuit PCB. On utilise alors un PCB 2b avec des fils 25 de câblage issus de plots 20 de connexion disposés sur sa périmétrie, de façon à être homogène avec les autres fils 15 de l'empilement 4 comme montré figure 4. L'interconnexion verticale se fait alors entre toutes les sections 151, 251 de fils sans passer par les conducteurs 21 du PCB.

Dans ces deux cas, le circuit d'interconnexion 2 peut comporter lui-même des composants 22 (généralement des composants passifs) qui :

○ sont noyés dans le PCB ce qui est la tendance actuelle selon un procédé « embedded die process » comme montré figures 3 et 4,
○ sont reportés par refusion et/ou câblage sur le verso (=bas) du PCB ou du substrat en alumine et ensuite moulés afin de présenter une surface plate, le recto servant à câbler les puces Chip on Chip.

Bien sûr, lorsqu'un PCB ou un substrat en alumine avec composants est utilisé de manière standard sans fils de câblage, la découpe selon D à travers le PCB ou le substrat en alumine est réalisée en dehors des composants comme on peut le voir figure 3.

Un empilement 4 est alors formé sur ce PCB selon les premières étapes du procédé de fabrication de type Chip on Chip. Une première puce est collée sur le PCB puis câblée avec les fils 15, une deuxième puce est collée sur la première puce puis câblée, une troisième puce est collée sur le niveau précédent puis câblée, etc. Chaque niveau de l'empilement peut comporter une ou plusieurs puces 1 : on parle donc de tranche électronique 16 comportant au moins une puce 1. Les étapes suivantes décrites en relation avec les figures 3 et 4, sont réalisées collectivement :

A) empilement d'une tranche 16 sur le circuit d'interconnexion 2 au moyen d'une colle 12 de type époxy par exemple, et connexion des plots 10 de la puce (ou des puces) de la tranche 16 à un substrat métallisé 6 disposé au niveau du PCB 2, par des fils de câblage électrique 15, de manière à obtenir des fils de câblage obliques, c'est-à-dire inclinés dans un plan vertical selon z comme montré figure 2b ; itération de cette étape en empilant une nouvelle tranche sur la tranche inférieure jusqu'à obtenir un empilement de tranches prédéfini, d'au moins deux tranches, et comportant typiquement 4 à 9 tranches. Le substrat support 6 pourrait faire partie du PCB 2 mais il est moins couteux d'utiliser un support plus simple qui n'a pas besoin d'avoir plusieurs niveaux d'interconnexion comme le PCB puisque sa fonction n'est que de supporter les soudures 30 des différents fils 15. Un support 6 métallique comme une feuille en cuivre métallisée avec du nickel et de l'or suffit.
B) dépôt d'une résine époxy 5 pour mouler l'empilement 4 avec les fils de câblage obliques 15 (et éventuellement 25), ainsi que le PCB 2,
C) découpe de la résine 5 selon quatre plans verticaux de découpe situés en dehors de l'empilement pour obtenir plusieurs boîtiers. Les sections de l'ensemble des fils 15 apparaissent sur les 1, 2, 3 ou 4 faces du module, les fils de câblage formant un angle oblique dans les plans de découpe correspondants. Lorsqu'on utilise un PCB standard 2a, un (ou plusieurs) plan(s) D de coupe verticale traverse le PCB, comme montré figure 3, tout en étant typiquement situé à environ 0,2 mm du bord de la puce 1 à plus grande surface horizontale.

Lorsqu'on utilise un PCB 2b avec fils de câblage comme montré figure 4, le procédé de fabrication comporte une étape préalable (avant étape A)) de connexion des plots 20 du circuit PCB 2b au substrat métallisé 6 par des fils de câblage 25, de manière à obtenir des fils de câblage obliques, comme dans l'étape A. Un plan de coupe verticale de l'étape C) est situé entre le circuit PCB 2b (à surface horizontale plus grande que celles des tranches empilées dessus) et le substrat métallisé 6.

D) Cette étape D est réalisée individuellement pour chaque boîtier : métallisation puis gravure des quatre faces verticales du boîtier pour former les bus métalliques 41 de connexion reliant les sections 151 des fils de câblage 15 et éventuellement les sections 251, au circuit PCB 2, et ainsi obtenir un module électronique 3D. Ces bus verticaux 41 sont quasiment plans : ils présentent une épaisseur inférieure à 10 $\mu$m (considérée dans une direction perpendiculaire à z).

Selon une alternative les étapes C et D sont remplacées par les étapes collectives suivantes :

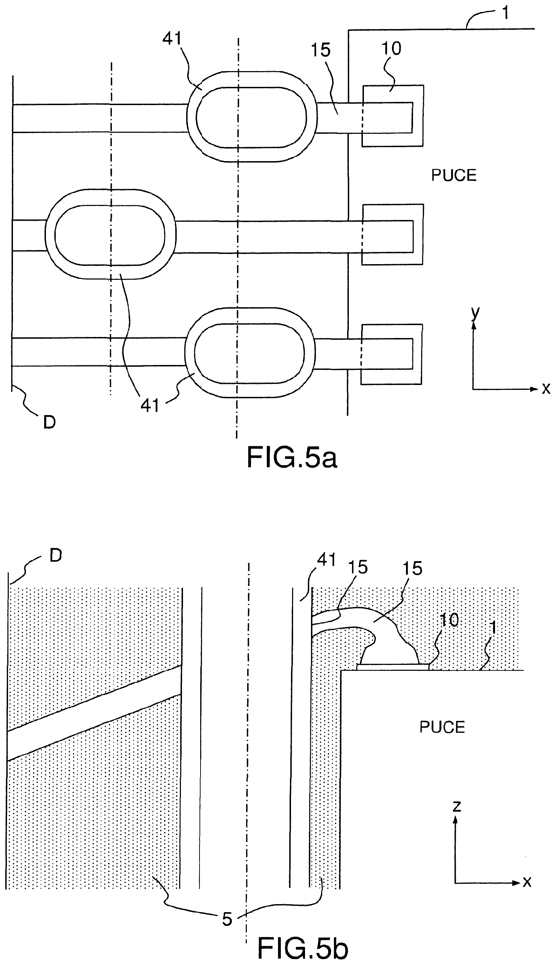

C') percements de vias verticaux à travers la résine 5 déposée à l'étape B et en dehors de l'empilement 4, les fils de câblage 15 formant un angle oblique avec ces vias comme montré figure 5b, et métallisation des vias pour former les bus verticaux 41 de connexion des sections des fils de câblage, au circuit PCB. Ils sont éventuellement disposés selon des plans parallèles comme montré figure 5a. Cette technique est décrite dans les brevets n° 2 895 568 et n° 2 923 081 (inventeur : Christian Val). Selon le PCB utilisé, le percement des vias est effectué à travers le PCB pour un PCB standard sans fils de câblage, ou entre le circuit PCB et le substrat métallisé pour un PCB avec fils de câblage.

D') découpe verticale de l'ensemble au-delà des vias, selon D pour obtenir plusieurs modules électroniques 3D.

On obtient ainsi un module électronique 3D à interconnexion par les faces verticales de l'empilement, les fils de câblage issus des puces formant un angle non droit (a2) avec le plan vertical des interconnexions. Les réflexions des électrons sont ainsi évitées, notamment aux fréquences élevées (au-delà d'1 GHz).

Pour assurer l'intégrité des signaux d'une puce à l'autre, notamment pour des signaux à fréquence élevée (> 1 GHz), il est nécessaire d'avoir entre les signaux la même impédance (ou la plus identique possible), autrement dit il est nécessaire d'avoir des conducteurs électriques de même longueur car les inductances et capacités parasites sont les mêmes dans le cas de conducteurs de même longueur.

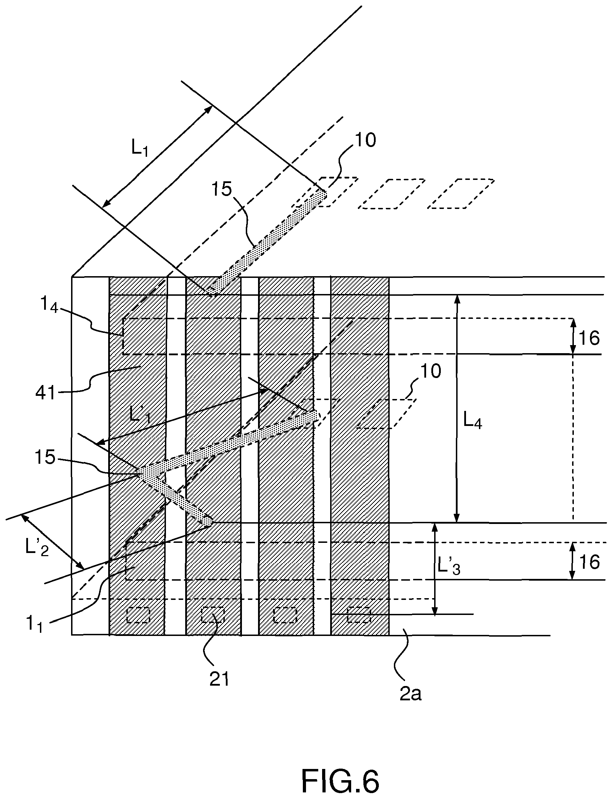

La longueur d'un conducteur électrique 15 entre le plot 10 de la puce $1_4$ (montrée figure 6) de la tranche 16 située en haut de l'empilement 4 et le PCB 2a ou 2b, via le bus vertical 41, est a priori bien supérieure à la longueur du conducteur électrique 15 entre le plot 10 de la puce $1_1$ de la tranche 16 située en bas de l'empilement 4 et le PCB 2a ou 2b, via le même bus vertical 41. Cette longueur de connexion électrique varie d'une puce à l'autre en fonction de sa position (en hauteur) dans l'empilement et éventuellement de sa position en xy dans le plan de la tranche lorsqu'il y a plusieurs puces par tranche. Selon l'invention, on compense ces différences de longueurs en augmentant par un câblage non rectiligne, la longueur du fil de câblage entre le plot de la puce et la connexion avec le bus vertical c'est-à-dire avant sa connexion au bus vertical. Dit autrement, la longueur du conducteur électrique est adaptée pour compenser sa longueur verticale de manière à ce que tous les conducteurs aient même longueur totale (du plot jusqu'au circuit d'interconnexion). Plus précisément, comme les conducteurs verticaux 41 sont droits qu'ils soient gravés ou sous forme de vias métallisés, il s'agit donc d'adapter les longueurs précédentes, c'est-à-dire celles des fils de câblage. Le routage d'un conducteur entre le plot 10 de la puce et le bus vertical 41 correspondant n'est donc pas toujours droit de ce fait. Ainsi comme on peut le voir figure 6 :

- le conducteur électrique correspondant à la puce de la première tranche 16 (en bas, puce $1_1$) mesure : L1' + L2' + L3', avec L1' + L2' la longueur du fil non rectiligne 15 câblé depuis le plot $10_1$ de la puce jusqu'à l'interception avec le bus métal 41, et L3' la distance sur le bus 41 entre cette interception et un conducteur 21 du PCB 2a ;
- le conducteur correspondant à la puce de la dernière tranche 16 (en haut, puce $1_4$ ; on n'a pas représenté les tranches intermédiaires) mesure : L1 + L4+ L3', avec L1 la longueur du fil rectiligne 15 câblé depuis le plot $10_4$ de la puce jusqu'à l'interception avec le même bus métal 41, et L4+ L3' la distance sur le bus 41 entre cette interception et le conducteur 21 du PCB 2a.

L4 étant imposé par le niveau de la tranche dans l'empilement, et L1 étant généralement déterminé par un câblage rectiligne entre le plot et l'interception avec le bus vertical, compenser les différences de longueurs des conducteurs revient donc à choisir L1' et L2' pour avoir :

$$L1' + L2' = L1 + L4.$$

Sur la figure et pour ne pas la surcharger, on n'a représenté qu'un seul conducteur par tranche. Bien sûr cette compensation de longueur s'applique à tous les conducteurs concernés. Pour une même tranche, les câblages non rectilignes peuvent être réalisés avec des fils de câblage métallique qui ne se croisent pas (ne se touchent pas), ou bien avec des fils de câblage isolés qui peuvent alors se croiser.

Ce câblage non rectiligne peut être réalisé industriellement grâce aux nouveaux équipements de câblage des puces qui ont été développés pour faciliter le routage des fils pour les techniques de Chip on Chip (fils qui peuvent être amenés à se croiser) ; le procédé de fabrication selon l'invention n'utilise pas ce dispositif pour éviter les croisements mais pour assurer une impédance constante.

D'une tranche à l'autre de l'empilement, les puces 1 peuvent être identiques mais pas nécessairement. Dans le cas de puces différentes, il est généralement nécessaire de différencier d'une tranche à l'autre, le câblage (le chemin) des fils de câblage entre les plots 10 d'une puce et leur connexion 151 aux bus verticaux. Dans le cas de puces identiques, les fils de câblage issus d'un même plot sont généralement court-circuités pour des puces identiques d'une tranche à l'autre, par le bus vertical correspondant (il s'agit du même bus vertical). Mais il peut être nécessaire qu'un signal associé au plot d'une puce soit indépendant du signal associé au même plot d'une puce identique située dans une autre tranche. Dans tous ces cas où il est nécessaire de ne pas court-circuiter les fils de câblage, on réalise également un routage non direct pour rejoindre des bus verticaux différents. Mais il n'est pas nécessaire de compenser les longueurs des fils de câblage car il n'est pas nécessaire d'obtenir des impédances identiques.

On peut intercaler dans l'empilement 4 un circuit PCB comportant des composants passifs 22. En effet ces composants passifs ne peuvent être câbler avec des fils 15 car leurs plots de câblage ne sont prévus que pour du report par refusion de brasure et il n'est pas possible de les câbler. Dans ce cas ces composants peuvent être reportés et brasés conventionnellement sur un PCB qui est intercalé dans l'empilement 4. Ce PCB sera plutôt sous la forme standard 2a.

**Revendications**

1. Module électronique 3D comportant selon une direction dite verticale un empilement (4) de tranches électroniques (16), chaque tranche comportant au moins une puce (1) munie de plots d'interconnexion (10), cet empilement étant assemblé à un circuit d'interconnexion (2a, 2b) du module muni de billes de connexion, les plots (10) de chaque puce étant connectés par des fils de câblage électrique (15) à des bus verticaux (41) eux-mêmes électriquement reliés au circuit (2a, 2b) d'interconnexion du module, un fil de câblage et le bus vertical auquel il est relié formant un conducteur électrique entre un plot d'une puce et le circuit d'interconnexion, chaque fil de câblage électrique (15) étant relié à son bus vertical (41) en formant dans un plan vertical un angle ($\alpha$2) oblique, la longueur du fil de câblage entre un plot d'une puce d'une tranche et un bus vertical étant différente de la longueur du fil de câblage entre un même plot d'une puce d'une autre tranche et ledit bus vertical, l'empilement de tranches, le circuit d'interconnexion et les fils de câblage étant moulés dans une résine époxy, les bus verticaux étant situés dans le moulage en résine époxy ou sur une ou plusieurs surfaces verticales du moulage en résine époxy, **caractérisé en ce que** ladite différence de longueur des fils de câblage est obtenue par un câblage non rectiligne du fil de câblage pour compenser la différence de longueur verticale du bus vertical d'une tranche à l'autre, de manière à ce que le conducteur électrique entre le plot d'une puce d'une tranche et le circuit d'interconnexion, et le conducteur électrique entre ledit même plot d'une puce de l'autre tranche et le circuit d'interconnexion, aient la même longueur.

2. Module électronique 3D selon la revendication précédente, **caractérisé en ce que** le circuit d'interconnexion (2b) comporte des fils de câblage électrique (25) reliés à des bus verticaux en formant des angles obliques et **en ce que** les bus verticaux (41) sont dans un plan situé en dehors du circuit d'interconnexion.

3. Module électronique 3D selon la revendication 1, **caractérisé en ce que** le circuit d'interconnexion (2a) ne comporte pas de fils de câblage et **en ce que** les bus verticaux (41) traversent le circuit d'interconnexion.

4. Module électronique 3D selon l'une des revendications précédentes, **caractérisé en ce que** les puces sont aptes à fonctionner à plus d'1 GHz.

5. Module électronique 3D selon l'une des revendications précédentes, **caractérisé en ce que** le nombre de tranches (16) empilées est compris entre 4 et 9.

6. Module électronique 3D selon l'une des revendications précédentes, **caractérisé en ce que** les bus verticaux (41) situés sur une ou plusieurs faces verticales du moulage en résine époxy présentent une épaisseur inférieure à 10$\mu$m, l'épaisseur d'un bus vertical étant la distance entre la surface extérieure dudit bus vertical et la surface de moulage en résine époxy sur laquelle ledit bus vertical se situe.

**7.** Module électronique 3D selon l'une des revendications précédentes 1 à 5, **caractérisé en ce que** les bus verticaux (41) sont sous forme de vias métallisés.

**8.** Module électronique 3D selon l'une des revendications précédentes, **caractérisé en ce qu'**un circuit électronique à composants passifs (22) et comportant des fils de câblage électrique (25) est inséré dans l'empilement (4).

**9.** Procédé de fabrication d'un module électronique 3D selon l'une des revendications 1 à 6, **caractérisé en ce qu'**il comporte les étapes suivantes réalisées collectivement :

A) empilement d'une tranche électronique (16) sur le circuit d'interconnexion (2a, 2b), et connexion des plots (10) de la puce (1) (ou des puces) à un substrat métallisé (6) situé au même niveau que le circuit d'interconnexion (2a, 2b), par des fils de câblage électrique (15), de manière à obtenir des fils de câblage inclinés dans un plan vertical, itération de cette étape avec une nouvelle tranche électronique empilée sur l'empilement précédent jusqu'à obtenir un empilement (4) prédéfini,

B) dépôt d'une résine époxy (5) pour mouler l'empilement et ses fils de câblage, et le circuit d'interconnexion,

C) découpe verticale de la résine selon des plans verticaux situés en dehors de l'empilement pour obtenir plusieurs boîtiers,

et **en ce qu'**il comporte l'étape suivante réalisée individuellement pour chaque boîtier : métallisation et gravure des faces verticales du boîtier pour former les bus verticaux (41) et obtenir un module électronique 3D.

**10.** Procédé de fabrication d'un module électronique 3D selon l'une des revendications 1 à 5, **caractérisé en ce qu'**il comporte les étapes suivantes réalisées collectivement :

A) empilement d'une tranche électronique (16) sur le circuit d'interconnexion (2a, 2b), et connexion des plots (10) de la puce (1) (ou des puces) à un substrat métallisé (6) situé au même niveau que le circuit d'interconnexion, par des fils de câblage (15), de manière à obtenir des fils de câblage inclinés dans un plan vertical, itération de cette étape avec une nouvelle tranche électronique empilée sur l'empilement précédent jusqu'à obtenir un empilement (4) prédéfini,

B) dépôt d'une résine époxy (5) pour mouler l'empilement et ses conducteurs, et le circuit d'interconnexion,

C) percements de vias à travers la résine en dehors de l'empilement, et métallisation des vias pour former les bus verticaux (41),

D) découpe verticale de la résine (5) selon des plans verticaux de découpe au-delà des vias pour obtenir plusieurs boîtiers.

**11.** Procédé de fabrication d'un module électronique 3D selon l'une des revendications 9 à 10, **caractérisé en ce que** le circuit d'interconnexion (2a) ne comporte pas de fils de câblage électrique et **en ce que** la découpe est réalisée dans au moins un plan vertical de découpe traversant le circuit d'interconnexion.

**12.** Procédé de fabrication d'un module électronique 3D selon l'une des revendications 9 à 10, **caractérisé en ce que** le circuit d'interconnexion (2b) comporte des fils de câblage (25) reliés au substrat métallisé (6) avant l'étape de dépôt de la résine, **en ce que** la découpe est réalisée dans au moins un plan vertical de découpe situé entre le circuit d'interconnexion et le substrat métallisé et **en ce que** les fils de câblage (25) du circuit d'interconnexion forment dans le plan vertical de découpe, un angle oblique.

**Patentansprüche**

**1.** Elektronisches 3D-Modul, das einen Stapel (4) von elektronischen Wafern (16) in einer vertikal genannten Richtung umfasst, wobei jeder Wafer wenigstens einen Chip (1) umfasst, der mit Verbindungspads (10) ausgestattet ist, wobei dieser Stapel mit einer Verbindungsschaltung (2a, 2b) des mit Anschlusskugeln ausgestatteten Moduls zusammengesetzt wird, wobei die Pads (10) jedes Chips durch elektrische Leitungsdrähte (15) mit vertikalen Bussen (41) verbunden sind, die wiederum elektrisch mit der Verbindungsschaltung (2a, 2b) des Moduls verbunden sind, wobei ein Leitungsdraht und der vertikale Bus, mit dem er verbunden ist, einen elektrischen Leiter zwischen einem Pad eines Chips und der Verbindungsschaltung bilden, wobei jeder elektrische Leitungsdraht (15) mit seinem vertikalen Bus (41) verbunden ist, unter Bildung eines schrägen Winkels (a2) in einer vertikalen Ebene, wobei sich die Länge des Leitungsdrahts zwischen einem Pad eines Chips eines Wafers und einem vertikalen Bus von der Länge des Leitungsdrahts zwischen einem selben Pad eines Chips eines anderen Wafers und dem vertikalen Bus unterscheidet und, wobei der vertikale Bus, der Waferstapel, die Verbindungsschaltung und die Leitungsdrähte aus einem Epoxidharz geformt sind, wobei sich die vertikalen Busse in der Epoxidharzform oder auf einer von mehreren vertikalen Flächen der Epoxidharzform befinden, **dadurch gekennzeichnet, dass** die Längendifferenz der Leitungsdrähte durch eine nicht geradlinige Verlegung des Leitungsdrahts erhalten wird, um die vertikale Längendifferenz des vertikalen Busses von einem Wafer zum anderen zu kompensieren, so dass der elektrische Leiter zwischen dem Pad eines Chips eines Wafers und der Verbindungsschaltung und der elektrische Leiter zwischen demselben Pad eines Chips des anderen Wafers und der Verbindungsschaltung dieselbe Länge haben.

2. Elektronisches 3D-Modul nach dem vorherigen Anspruch, **dadurch gekennzeichnet, dass** die Verbindungsschaltung (2b) elektrische Leitungsdrähte (25) umfasst, die mit vertikalen Bussen unter Bildung von schrägen Winkeln verbunden sind, und dadurch, dass die vertikalen Busse (41) in einer Ebene liegen, die sich außerhalb der Verbindungsschaltung befindet.

3. Elektronisches 3D-Modul nach Anspruch 1, **dadurch gekennzeichnet, dass** die Verbindungsschaltung (2a) keine Verbindungsdrähte umfasst, und dadurch, dass die vertikalen Busse (41) durch die Verbindungsschaltung hindurch gehen.

4. Elektronisches 3D-Modul nach einem der vorherigen Ansprüche, **dadurch gekennzeichnet, dass** die Chips mit mehr als 1 GHz arbeiten können.

5. Elektronisches 3D-Modul nach einem der vorherigen Ansprüche, **dadurch gekennzeichnet, dass** die Anzahl von gestapelten Wafern (16) 4 bis 9 beträgt.

6. Elektronisches 3D-Modul nach einem der vorherigen Ansprüche, **dadurch gekennzeichnet, dass** die vertikalen Busse (41), die sich auf einer oder mehreren vertikalen Flächen der Epoxidharzform befinden, eine Dicke von weniger als 10 $\mu$m haben, wobei die Dicke eines vertikalen Busses der Abstand zwischen der Außenfläche des vertikalen Busses und der Oberfläche der Epoxidharzform ist, auf der sich der vertikale Bus befindet.

7. Elektronisches 3D-Modul nach einem der Ansprüche 1 bis 5, **dadurch gekennzeichnet, dass** die vertikalen Busse (41) in Form von metallisierten Durchkontaktierungen vorliegen.

8. Elektronisches 3D-Modul nach einem der vorherigen Ansprüche, **dadurch gekennzeichnet, dass** eine elektronische Schaltung mit passiven Komponenten (22), die elektrische Leitungsdrähte (25) umfasst, in den Stapel (4) eingefügt ist.

9. Verfahren zur Herstellung eines elektronischen 3D-Moduls nach einem der Ansprüche 1 bis 6, **dadurch gekennzeichnet, dass** es die folgenden kollektiv durchgeführten Schritte beinhaltet:

A) Stapeln eines elektronischen Wafers (16) auf der Verbindungsschaltung (2a, 2b) und Verbinden der Pads (10) des Chips (1) (oder der Chips) mit einem metallisierten Substrat (6), das sich auf demselben Niveau befindet wie die Verbindungsschaltung (2a, 2b), durch elektrische Leitungsdrähte (15), um Leitungsdrähte zu erhalten, die in einer vertikalen Ebene geneigt sind, Wiederholen dieses Schritts mit einem neuen elektronischen Wafer, der auf dem vorherigen Stapel gestapelt ist, um einen vordefinierten Stapel (4) zu erhalten,
B) Absetzen eines Epoxidharzes (5) zum Formen des Stapels und seiner Leitungsdrähte und der Verbindungsschaltung,
C) vertikales Abschneiden des Harzes gemäß vertikalen Ebenen, die sich außerhalb des Stapels befinden, um mehrere Gehäuse zu erhalten,

und dadurch, dass es den folgenden individuell für jedes Gehäuse durchgeführten Schritt beinhaltet: Metallisieren und Ätzen der vertikalen Flächen des Gehäuses zum Bilden der vertikalen Busse (41) und Erhalten eines elektronischen 3D-Moduls.

10. Verfahren zur Herstellung eines elektronischen 3D-Moduls nach einem der Ansprüche 1 bis 5, **dadurch gekennzeichnet, dass** es die folgenden kollektiv durchgeführten Schritte beinhaltet:

A) Stapeln eines elektronischen Wafers (16) auf der Verbindungsschaltung (2a, 2b) und Verbinden der Pads (10) des Chips (1) (oder der Chips) mit einem metallisierten Substrat (6), das sich auf demselben Niveau befindet wie die Verbindungsschaltung, durch Leitungsdrähte (15), um Leitungsdrähte zu erhalten, die in einer vertikalen Ebene geneigt sind, Wiederholen dieses Schrittes mit einem neuen elektronischen Wafer, der auf dem vorherigen Stapel gestapelt ist, bis ein vordefinierter Stapel (4) erhalten ist,
B) Absetzen eines Epoxidharzes (5) zum Formen des Stapels und seiner Leiter und der Verbindungsschaltung,
C) Bohren von Durchkontaktierungen durch das Harz außerhalb des Stapels und Metallisieren der Durchkontaktierungen zum Bilden der vertikalen Busse (41),
D) vertikales Durchschneiden des Harzes (5) gemäß vertikaler Schnittebenen jenseits der Durchkontaktierungen, um mehrere Gehäuse zu erhalten.

**11.** Verfahren zur Herstellung eines elektronischen 3D-Moduls nach einem der Ansprüche 9 bis 10, **dadurch gekennzeichnet, dass** die Verbindungsschaltung (2a) keine elektrischen Leitungsdrähte umfasst, und dadurch, dass der Schnitt in wenigstens einer vertikalen Schnittebene durchgeführt wird, die durch die Verbindungsschaltung hindurch geht.

**12.** Verfahren zur Herstellung eines elektronischen 3D-Moduls nach einem der Ansprüche 9 bis 10, **dadurch gekennzeichnet, dass** die Verbindungsschaltung (2b) Leitungsdrähte (25) umfasst, die vor dem Schritt des Absetzens des Harzes mit dem metallisierten Substrat (6) verbunden werden, dadurch, dass der Schnitt in wenigstens einer vertikalen Schnittebene durchgeführt wird, die sich zwischen der Verbindungsschaltung und dem metallisierten Substrat befindet, und dadurch, dass die Leitungsdrähte (25) der Verbindungsschaltung in der vertikalen Schnittebene einen schrägen Winkel bilden.

**Claims**

**1.** A 3D electronic module including, in a direction referred to as the vertical direction, a stack (4) of electronic dice (16), each die including at least one chip (1) provided with interconnect pads (10), this stack being attached to an interconnect circuit (2a, 2b) of the module provided with connection bumps, the pads (10) of each chip being connected by electrical bonding wires (15) to vertical buses (41) that are themselves electrically linked to the interconnect circuit (2a, 2b) of the module, a bonding wire and the vertical bus to which it is linked forming an electrical conductor between a pad of a chip and the interconnect circuit, each electrical bonding wire (15) being linked to its vertical bus (41) by forming, in a vertical plane, an oblique angle ($\alpha2$) and in that the length of the bonding wire between a pad of a chip of one die and a vertical bus being different than the length of the bonding wire between one and the same pad of a chip of another die and said vertical bus, the stack of dice, the interconnection circuit and the bonding wires being molded in an epoxy resin, the vertical buses being located in the epoxy resin molding or on one or more vertical surfaces of the epoxy resin molding, **characterized in that** said difference in length of the bonding wires is obtained by a bonding wire in a non-rectilinear manner to compensate for the difference in vertical length of the vertical bus from one die to the other, such that the electrical conductor between the pad of a chip of one die and the interconnect circuit, and the electrical conductor between said same pad of a chip of the other die and the interconnect circuit, are of the same length.

**2.** The 3D electronic module as claimed in the preceding claim, **characterized in that** the interconnect circuit (2b) includes electrical bonding wires (25) that are linked to vertical buses by forming oblique angles and **in that** the vertical buses (41) are in a plane located outside the interconnect circuit.

**3.** The 3D electronic module as claimed in claim 1, **characterized in that** the interconnect circuit (2a) does not include any bonding wires and **in that** the vertical buses (41) pass through the interconnect circuit.

**4.** The 3D electronic module as claimed in one of the preceding claims, **characterized in that** the chips are capable of running at over 1 GHz.

**5.** The 3D electronic module as claimed in one of the preceding claims, **characterized in that** the number of stacked dice (16) is comprised between 4 and 9.

**6.** The 3D electronic module as claimed in one of the preceding claims, **characterized in that** the vertical buses (41) which are located on one or more vertical faces of the epoxy resin molding have a thickness which is less than 10$\mu$m, the thickness of a vertical bus being the distance between the outer surface of said vertical bus and the epoxy resin molding surface on which said vertical bus is located.

**7.** The 3D electronic module as claimed in one of the preceding claims 1 to 5, **characterized in that** the vertical buses (41) take the form of metallized vias.

**8.** The 3D electronic module as claimed in one of the preceding claims, **characterized in that** an electronic circuit with passive components (22) and including electrical bonding wires (25) is inserted into the stack (4).

**9.** A process for fabricating a 3D electronic module as claimed in one of claims 1 to 6, **characterized in that** it includes the following steps carried out collectively:

A) stacking an electronic die (16) on the interconnect circuit (2a, 2b), and connecting pads (10) of the chip (1) (or chips) to a metallized substrate (6) that is located at the same level as the interconnect circuit (2a, 2b) by means of electrical bonding wires (15) so as to obtain bonding wires that are inclined in a vertical plane, iterating this step with a new electronic die stacked on top of the preceding stack until a predefined stack (4) is obtained;

B) depositing an epoxy resin (5) to mold the stack and its bonding wires, and the interconnect circuit;

C) vertically cutting through the resin along vertical planes that are located outside the stack to obtain a plurality of packages;

and **in that** it includes the following step carried out individually for each package: metallizing and etching the vertical faces of the package so as to form the vertical buses (41) and to obtain a 3D electronic module.

10. A process for fabricating a 3D electronic module as claimed in one of claims 1 to 5, **characterized in that** it includes the following steps carried out collectively:

A) stacking an electronic die (16) on top of the interconnect circuit (2a, 2b), and connecting pads (10) of the chip (1) (or chips) to a metallized substrate (6) that is located at the same level as the interconnect circuit by means of bonding wires (15) so as to obtain bonding wires that are inclined in a vertical plane, iterating this step with a new electronic die stacked on top of the preceding stack until a predefined stack (4) is obtained;
B) depositing an epoxy resin (5) to mold the stack and its conductors, and the interconnect circuit;
C) drilling vias through the resin outside the stack, and metallizing the vias to form the vertical buses (41);
D) vertically cutting through the resin (5) along vertical cutting planes beyond the vias to obtain a plurality of packages.

11. The process for fabricating a 3D electronic module as claimed in either of claims 9 and 10, **characterized in that** the interconnect circuit (2a) does not include any electrical bonding wires and **in that** the cutting operation is performed through at least one vertical cutting plane passing through the interconnect circuit.

12. The process for fabricating a 3D electronic module as claimed in either of claims 9 and 10, **characterized in that** the interconnect circuit (2b) includes bonding wires (25) that are linked to the metallized substrate (6) before the step of depositing the resin, **in that** the cutting operation is performed through at least one vertical cutting plane located between the interconnect circuit and the metallized substrate and **in that** the bonding wires (25) from the interconnect circuit form, in the vertical cutting plane, an oblique angle.

FIG.1

FIG.2a

FIG.2b

FIG.3

FIG.4

**FIG.5a**

PUCE

**FIG.5b**

PUCE

FIG.6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2857157, Val Christian et Lignier Olivier
- FR 2905198, Val Christian
- WO 2014063287 A
- WO 2895568 A
- WO 2923081 A, Christian Val